# EUROPÄISCHE PATENTSCHRIFT

(11) **EP 1 908 091 B1**
(45) Veröffentlichungstag und Bekanntmachung des Hinweises auf die Patenterteilung: **12.02.2020**
(21) Anmeldenummer: 06762519.4
(22) Anmeldetag: 11.07.2006
(51) Int. Cl.: H01J 37/34, C23C 14/35

(54) **VERFAHREN UND VORRICHTUNG ZUR MEHRKATHODEN-PVD-BESCHICHTUNG UND SUBSTRAT MIT PVD-BESCHICHTUNG**
METHOD AND DEVICE FOR MULTI-CATHODE-PVD-COATING AND SUBSTRATE HAVING PVD-COATING
PROCEDE ET DISPOSITIF POUR LE REVETEMENT PAR DEPOT PHYSIQUE EN PHASE GAZEUSE A PLUSIEURS CATHODES ET SUBSTRAT MUNI D'UN REVETEMENT PAR DEPOT PHYSIQUE EN PHASE GAZEUSE

(30) Priorität: 15.07.2005 DE 102005033769
(43) Veröffentlichungstag der Anmeldung: 09.04.2008
(73) Patentinhaber: Systec System- und Anlagentechnik GmbH & Co. KG, 97753 Karlstadt (DE)
(72) Erfinder: MÜNZ, Wolf-Dieter, A-1090 Wien (AT); HOFMANN, Dieter, 63571 Gelnhausen (DE); KUNKEL, Stefan, 63599 Biebergemünd (DE); MANGOLD, Jürgen, 97711 Rothhausen (DE); SCHÜSSLER, Hans, 66578 Schiffweiler (DE)
(74) Vertreter: Zounek, Nikolai
(86) Internationale Anmeldenummer: PCT/EP2006/006768
(87) Internationale Veröffentlichungsnummer: WO 2007/009634

(56) Entgegenhaltungen:
- EP-A2- 1 260 603
- WO-A-98/40532
- WO-A2-2004/031435
- DE-A1- 19 547 305
- US-A1- 2005 109 607
- YAMAMOTO ET AL: "Properties of nano-multilayered hard coatings deposited by a new hybrid coating process: Combined cathodic arc and unbalanced magnetron sputtering" SURFACE AND COATINGS TECHNOLOGY, ELSEVIER, AMSTERDAM, NL, Bd. 200, Nr. 1-4, 1. Oktober 2005 (2005-10-01), Seiten 435-439, XP005063547 ISSN: 0257-8972
- EHIASARIAN A P ET AL: "Comparison of microstructure and mechanical properties of chromium nitride-based coatings deposited by high power impulse magnetron sputtering and by the combined steered cathodic arc/unbalanced magnetron technique" PREPARATION AND CHARACTERIZATION, ELSEVIER SEQUOIA, NL, Bd. 457, Nr. 2, 15. Juni 2004 (2004-06-15), Seiten 270-277, XP004507225 ISSN: 0040-6090
- MÜNZ W-D: "Large-Scale Manufacturing of Nanoscale Multilayered Hard Coatings Deposited by Cathodic Arc/Unbalanced Magnetron Sputtering", MRS BULLETIN, PITTSBURGH, US, vol. 28, no. 3, 1 March 2003 (2003-03-01), pages 173-179, XP002301638,
- PAULITSCH J ET AL: "Structure and mechanical properties of CrN/TiN multilayer coatings prepared by a combined HIPIMS/UBMS deposition technique", THIN SOLID FILMS, ELSEVIER-SEQUOIA S.A. LAUSANNE, CH, vol. 517, no. 3, 1 December 2008 (2008-12-01), pages 1239-1244, XP025712317, ISSN: 0040-6090, DOI: 10.1016/J.TSF.2008.06.080 [retrieved on 2008-06-28]
- EHIASARIAN A P ET AL: "High power pulsed magnetron sputtered CrNx films", SURFACE AND COATINGS TECHNOLOGY, ELSEVIER BV, AMSTERDAM, NL, vol. 163-164, 1 January 2003 (2003-01-01), pages 267-272, XP002445020, ISSN: 0257-8972, DOI: 10.1016/S0257-8972(02)00479-6

## Beschreibung

Die Erfindung betrifft ein Verfahren und eine Vorrichtung zur Mehrkathoden-PVD-Beschichtung von Substraten.

Die Kathodenzerstäubung hat im Bereich der PVD-Beschichtung zusehend an Bedeutung gewonnen. Sowohl die Materialvielfalt wie auch Reproduzierbarkeit des Beschichtungsverfahrens haben zu dieser Entwicklung beigetragen. Neben monolithisch aufgebauten Schichtstrukturen haben im letzten Jahrzehnt Mehrlagen-Schicht-Architekturen an Einfluß gewonnen. Insbesondere im Bereich der nano-skalierten Mehrlagenschichten und der sog. Übergitter-Schichten (Superlattice) werden herausragende Schichteigenschaften hinsichtlich Verschleißfestigkeit, Oxidationsbeständigkeit und Korrosionsbeständigkeit erzielt.

Insbesondere die Härte der kondensierten nanokristallinen Schichten konnte erheblich gesteigert werden, nämlich bis auf ca. 50 % der Diamanthärte, d.h. bis auf ca. 50 GPa [1].

Diese neuartigen superharten Schichten weisen in der Regel enorme Druckspannungen auf und zwar bis über -7GPa. Aus diesem Grund spielt die Haftfestigkeit der kondensierten Schichten auf den Substraten, die üblicherweise aus Stahl, Hartmetall oder mittels galvanischer Schichten vorpräparierten Materialien bestehen, eine entscheidende Rolle.

Im Laufe der Entwicklung der Kathodenzerstäubung hat sich herausgestellt, daß die Haftfestigkeit derartiger superharter Schichtsysteme begrenzt ist, wenn die Substrate nur mit Argon-Ionen als in vacuo Reinigung vorbehandelt wurden.

Neben verfahrensmäßig aufwendig herzustellenden Mehrlagen-Zwischenschichten werden auch mechanische Vorbehandlungen [2] vorgenommen, um das Druckspannungsgefälle zwischen dem relativ weichen Substrat und der PVD-Schicht zu reduzieren.

Eine Metallionen-Vorbehandlung vor der eigentlichen Beschichtung reduziert die Druckspannungen. Diese Methode wurde im Rahmen der Beschichtungstechnik mittels kathodischer Bogenentladung [3] entwickelt.

In einer kathodischen Bogenentladung bildet sich ein Plasma aus, das in hoher Konzentration ein- bis mehrfach geladene Metallionen enthält [4].

Grundlegende Untersuchungen haben gezeigt [5, 6] daß bei kombinierter Vorbehandlung der Substrate mit Metallionen aus einer kathodischen Bogenentladung nachfolgende mit einem unbalancierten Magnetron (UBM) abgeschiedene Schichten ein punktuelles epitaktisches Schichtwachstum aufweisen, das eine erhöhte Haftung der Schichten bewirkt [7].

Empirisch ist dieser Zusammenhang schon länger bekannt [8, 9, 10] und wird im sogenannten Arc-Bond-Sputter-Verfahren industriell angewandt [11]. Nachteilig bei diesem Verfahren ist, daß während der Metallionen-Vorbehandlung die für kathodische Bogenentladungen typischen Makropartikel, sogenannte Droplets [12] entstehen, die zu unerwünschten Inhomogenitäten in der Schicht führen. Solche Inhomogenitäten beinflussen auch das an sich Droplet-freie, nachfolgende Beschichtungsverfahren mittels UBM nachteilig [13].

Aus der EP 1260603 A2 ist ein PVD-Verfahren zur Beschichtung von Subtraten bekannt, bei dem das Substrat im Plasma einer gepulsten magnetfeldgestützten Kathodenzerstäubung (HIPIMS) vorbehandelt wird. Während der Vorbehandlung wird eine Magnetron-Kathode zur Magnetfeldunterstützung eingesetzt. Nach der Vorbehandlung erfolgt eine Weiterbeschichtung z.B. mittels UBM-Kathodenzerstäubung. Für die Vorbehandlung und die Beschichtung werden identische Kathoden und identische Magnetfeldanordnungen benutzt.

Aus der EP 0521045 B1 ist ein Verfahren zur Ionenplattierung mit einem ersten und zweiten Magnetron bekannt, von denen jedes einen inneren Pol und einen äußeren Ringpol entgegengesetzter Polarität aufweist. Die Magnetrons sind so angeordnet, daß der äußere Ringpol eines Magnetrons und der äußere Ringpol des zweiten oder weiterer Magnetrons benachbart zu dem jeweils anderen angeordnet und von entgegengesetzter Polarität sind. Eines der Magnetrons wird im unbalancierten Zustand betrieben.

Die WO 98/40532 offenbart ein Verfahren und eine Vorrichtung mit magnetisch unterstützter Kathodenzerstäubung, wobei die Kathode mit Hochleistungpulsen betrieben wird (HIPIMS).

US 2005/109607 betrifft die Abscheidung von Mehrlagenbeschichtungen mittels unbalanciertem Magnetronsputtern (UBM), wobei vorab mittels Hochleistungs-Impuls-Magnetron-Katodenzerstäubung (HIPIMS) die Substratoberfläche gereinigt und eine Verankerungsschicht implantiert wird.

W.-D. Münz; Large-Scale Manufacturing of Nanoscale Multilayered Hard Coatings Deposited by Cathodic Arc / Unbalanced Magnetron Sputtering; MRS Bulletin, Vol. 28, No. 3, March 2003 beschreibt die Abscheidung von nanoskaligen Mehrlagenbeschichtungen mittels kathodischer Bogenentladung und unbalanciertem Magnetron-Kathodenzerstäubung (UBM). Die kathodische Bogenentladung wird zur Ätzung der Substratoberfläche und zur Implantation einer Verankerungsschicht eingesetzt. Lediglich in Ausnahmefällen werden Lagen aus bestimmten, für Kathodenvergiftung anfälligen Materialien, wie Zirkonnitrid ersatzweise mittels kathodischer Bogenentladung erzeugt.

Aufgabe der vorliegenden Erfindung ist es, ein Verfahren und eine Vorrichtung zur PVD-Beschichtung von Substraten zu schaffen, bei denen das Auftreten von Makropartikeln, die zu unerwünschten Inhomogenitäten in der Beschichtung führen, weitgehend vermieden wird und Mehrlagenschichten hoher Härte mit guter Haftung auf dem Substrat erzeugt werden.

Diese Aufgabe wird verfahrensgemäß durch folgende Schritte gelöst:
(a) Vorbehandlung der Substratoberfläche durch Hochleistungs-Impuls-Magnetron-Kathodenzerstäubung (HIPIMS),
(b) Beschichtung mittels Unbalancierter-Magnetron-Kathodenzerstäubung (UBM),
(c) Beschichtung mittels HIPIMS, und
(d) ein- bis mehrfache Wiederholung der Schritte (b) und (c).

In Weiterbildung des Verfahrens erfolgt der Schritt (a) mit einem Kathodentarget aus Metall in einer Gasatmosphäre bei einem Druck kleiner/gleich 1 · 10⁻² mbar und mit einem Substratpotential von -500 bis -2000 V, wobei die Substratoberfläche mit ein- bis mehrfach positiv geladenen Metallionen geätzt und implantiert wird.

Die weitere Ausgestaltung des Verfahrens ergibt sich aus den Patentansprüchen 3 bis 15.

Die erfindungsgemäße Vorrichtung zur Mehrkathoden-PVD-Beschichtung ist mit einer oder mehreren Prozeßkammern ausgestattet, wobei jede Prozeßkammer mindestens eine HIPIMS-Kathode und mindestens eine UBM-Kathode aufweist.

Die weitere Ausgestaltung der Vorrichtung ergibt sich aus den Patentansprüchen 17 bis 20.

Ein, wie vorstehend beschrieben, hergestelltes Substrat mit PVD-Beschichtung umfaßt eine durch HIPIMS in der Substratoberfläche erzeugte Implantationsschicht und eine oder mehrere mittels UBM und HIPIMS abgeschiedene Doppelschichten.

Mit der Erfindung wird der Vorteil erzielt, daß das Metallionen-Ätzen bei der Vorbehandlung mittels HIPIMS vonstatten geht und dadurch die Entstehung von Makropartikeln stark reduziert wird. Der Aufbau der Mehrlagenschichtarchitektur erfolgt durch simultanen Einsatz von UBM und HIPIMS.

Die spezielle Methode der HIPIMS-Kathodenzerstäubung wurde zunächst allein zur Abscheidung von PVD-Schichten benutzt [14]. Eine Berücksichtigung von HIPIMS beim Metall-Ionen-Ätzen als Substratvorbehandlung jedoch in strikter Kombination mit dem nachfolgenden Beschichten exklusiv mit dem unbalancierten Magnetron wurde erst kürzlich aufgezeigt [17]. Jedoch werden bei diesem Verfahren die UBM- und HIPIMS-Kathoden nicht simultan betrieben.

Die Erfindung wird im folgenden anhand der Zeichnungen näher erläutert. Es zeigen:
- Fig. 1: einen schematischen Schnitt durch ein Schichtsystem eines Substrats;
- Fig. 2: eine schematische Ansicht einer ersten Ausführungsform der erfindungsgemäßen Vorrichtung;
- Fig. 3: eine schematische Ansicht einer zweiten Ausführungsform der erfindungsgemäßen Vorrichtung; und
- Fig. 4: eine schematische Ansicht einer dritten Ausführungsform der erfindungsgemäßen Vorrichtung.

Das Verfahren zeichnet sich dadurch aus, daß ein Plasma erzeugt wird, und dass ähnlich wie bei der kathodischen Bogenentladung mehrfach geladene Metall-Ionen generiert werden, jedoch keine Makropartikel (Droplets) erzeugt werden.

Das Metall-Ionen-Ätzen geht vor dem Beschichten mit dem HIPIMS Verfahren von statten. Darüber hinaus wird das HIPIMS Verfahren jedoch simultan mit dem unbalancierten Magnetron (UBM) zur Beschichtung benutzt.

Die Erfindung besteht nicht alleine in der simultanen Anwendung der beiden Verfahrensweisen während der Beschichtung sondern auch in der Tatsache daß die Beschichtungsmaterialien für HIPIMS und UBM grundsätzlich unterschiedlich sind. So werden im HIPIMS-Verfahren zur Vorbehandlung Materialien wie Ti, Cr, Zr, V, Nb, Mo, Ta, W oder Al benutzt. Während der Beschichtung werden diese Materialien als Nitride, Carbide,

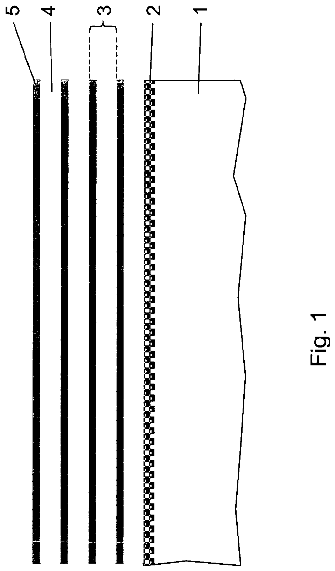

Carbon-Nitride, Oxide oder Oxynitride abgeschieden. Mit dem UBM werden Materialien abgeschieden die nicht identisch mit den mit dem HIPIMS abgeschiedenen Materialien sind. So kann wahrend mit HIPIMS CrN abgeschieden wird mit dem UBM simultan TiNx oder z.B. NbN abgeschieden werden. Somit entstehen Schichtsysteme vom Typ der in Fig. 1. gezeigten Schichten.

Mit dem UBM ist es auch möglich Multikomponentenmaterialien wie TiAl, TiAlY, CrAl, ZrAl oder reines Graphit zu zerstäuben, sodass Schichtfolgen wie z.B. CrN/TiAlN oder TiN/CrAlN oder W/C entstehen. Als besonders bevorzugte Abscheidungsbedingung gilt die Erzeugung von Schichten nach der Superlatticearchitektur [1, 18]. Dabei sind die Beschichtungsparameter so zu wählen, daß die Dicke der Doppelschicht z. B. VN/TiAlN ca. 3-5nm beträgt.

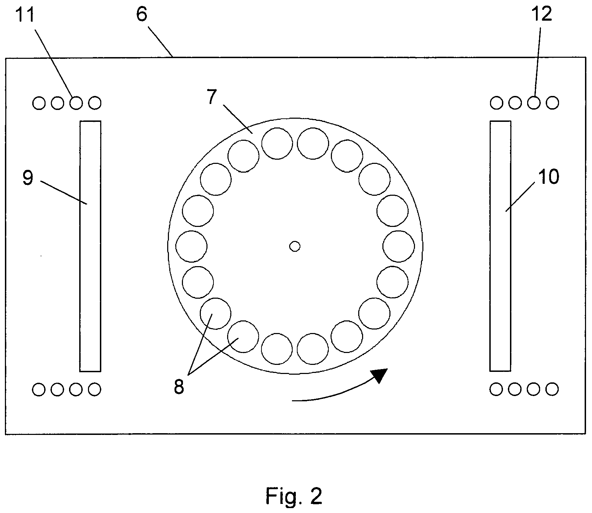

Um diese neuartigen Schichten zu verwirklichen, sind spezielle Kathodenanordnungen in den zu verwendenden PVD-Anlagen erforderlich. Fig. 2 bis 4 zeigen drei Basis-Konfigurationen der Prozeßkammern gemäß der Erfindung.

### Beispiel 1

Die in Fig. 2 dargestellte erste Ausführungsform einer Prozeßkammer 6 enthält zwei Beschichtungsquellen, dies sind eine HIPIMS-Kathode 9 und eine UBM-Kathode 10 und wird vorzugsweise in kleinen Anlagen eingesetzt. In einer Anlage mit einem Vakuumkessel von 700 mm Durchmesser und 700 mm Kesselhöhe (Innenmaße) werden 500 mm lange Linearkathoden eingesetzt. Die HIPIMS-Kathode 9 ist beispielsweise mit Wolfram Targetmaterial und die UBM-Kathode 10 ist mit Graphit als Targetmaterial ausgerüstet. Ein zwischen den Kathoden angeordneter rotierender Substratträger 7 hat einen Durchmesser von 400 mm und kann über eine Höhe von 400 mm bestückt werden. Auf dem Substratträger 7 sind z.B. 10 rotierende Planeten mit 50 mm Durchmesser eingesetzt, die mit für die Vakuumbeschichtung vorgereinigten, sauberen Substraten 8 bestückt sind. Die Substrate 8 können Bauteile für PKW, Armaturen, Beschläge und dergl. sein, die beispielsweise aus dem Werkstoff 100Cr6 gefertigt sind.

Nach dem Beladen der Anlage wird die Kammertür geschlossen und es wird durch Abpumpen in der Vakuumkammer der Kammerdruck von Atmosphäre bis zu einem Druck von < 5 · 10⁻⁵ mbar abgesenkt. Nachfolgend wird Argon in die Kammer eingelassen bis ein Druck von 2 · 10⁻³ mbar erreicht ist.

Die HIPIMS-Kathode 9 ist mit einem Solenoid-Elektromagneten 11 aussgestattet. Die UBM-Kathode 10 ist gleichfalls mit einem Solenoid-Elektromagneten 12 ausgerüstet.

Durch den Betrieb der HIPIMS-Kathode 9 wird bei gleichzeitigem Anlegen eines Substratpotentials von -1000 V mit einem kombinierten Ionenätzprozeß und Beschichtungsprozeß eine Wolfram-Implantationsschicht erzeugt.

Nachfolgend werden Argon und Acetylen in die Prozeßkammer eingeleitet und ein Druck von 5 · 10⁻³ mbar eingestellt. Gleichzeitig wird das negative Substratpotential auf -100 V vermindert und die UBM-Kathode 10 zugeschaltet.

Bei dem gleichzeitigem Betrieb der HIPIMS-Kathode 9 und der UBM-Kathode 10 wird ein mehrfacher Doppelschichtaufbau aus W/C, wie in Fig. 1 gezeigt, aufgebracht.

### Beispiel 2

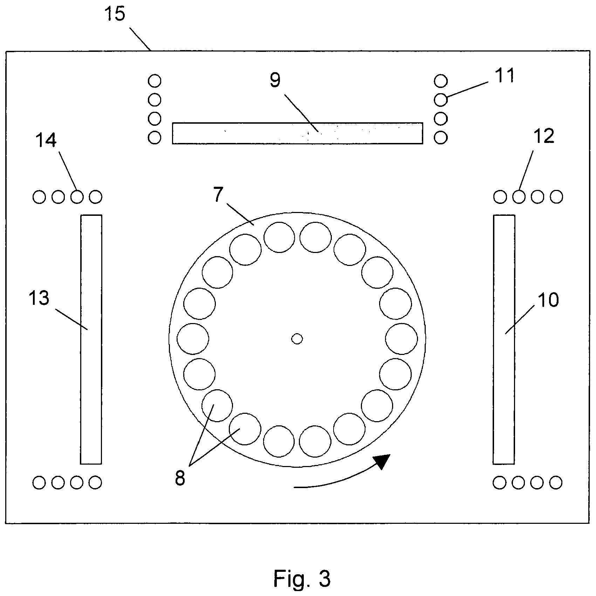

Die in Fig. 3 gezeigte zweite Ausführungsform einer Prozeßkammer 15 enthält drei Beschichtungsquellen, dies sind eine HIPIMS-Kathode 9 und zwei UBM-Kathoden 10, 13 und wird vorzugsweise für Cluster-Inline-Anlagen eingesetzt. In den Prozeßkammern der Cluster-Inline-Anlage vom Typ DeQoTec der Firma Systec System- und Anlagenbau GmbH & Co. KG., Karlstadt, Deutschland, mit Innenabmessungen der Kammer von 930 x 1720 x 550 mm (Länge x Höhe x Breite) werden 1350 mm lange Linearkathoden 9, 10, 13 eingesetzt. Die HIPIMS-Kathode 9 ist beispielsweise mit Titan Targetmaterial und die beiden UBM-Kathoden 10, 13 sind mit Graphit als Targetmaterial ausgerüstet. Der zwischen den Kathoden angeordnete rotierende Substratträger 7 hat einen Durchmesser von 300 mm und kann über eine Höhe von 1000 mm bestückt werden. Auf dem Substratträger 7 sind beispielsweise acht rotierende Planeten mit 50 mm eingesetzt, die mit für die Vakuumbeschichtung vorgereinigten, sauberen Substraten 8 bzw. Bauteilen aus Werkstoff 100Cr6 bestückt sind. Dieser Werksstoff wird beispielsweise für Kugellager verwendet.

Die HIPIMS-Kathode 9 ist mit einem Solenoid-Elektromagneten 11 und die beiden UBM-Kathoden 10, 13 sind mit Solenoid-Elektromagneten 12, 14 ausgerüstet.

Nach dem Beladen der Einschleus/Ausschleuskammer der Anlage wird die Kammertür geschlossen und es wird durch Abpumpen in der Vakuumkammer der Kammerdruck von Atmosphäre bis zu einem Druck von < 5 · 10⁻⁵ mbar abgesenkt. Die zwischen einer Zentralkammer und den Prozeßkammern befindlichen Öffnungen sind hierbei mit Dichtplatten verschlossen. Nachfolgend werden über einen zentralen Antriebsmechanismus, der sich in der Zentralkammer befindet, alle Dichtplatten, welche auch die Konsolen tragen, auf denen die Substratträger 8 eingesetzt sind, geöffnet und die Substratträger werden in die Zentralkammer hineinbewegt und dann durch eine 90° Drehbewegung vor der nächsten Prozeßkammer positioniert und in diese Kammer hineingefahren. Mit dem Erreichen der Endposition des Substratträgers in der aufnehmenden Prozeßkammer wird gleichzeitig durch die Dichtplatten wieder die Verbindung der Prozeßkammer zu der Zentralkammer verschlossen.

In der auf die Einschleus/Ausschleuskammer folgenden Prozeßkammer befindet sich die oben beschriebene Kathodenanordnung. In diese Prozeßkammer wird nun Argon eingelassen bis ein Druck von 3 · 10⁻³ mbar erreicht wird.

Durch den Betrieb der HIPIMS-Kathode 9 wird beim gleichzeitigem Anlegen eines Substratpotentials von -1100 V durch einen simultanen Ionenätzprozeß und Beschichtungsprozeß eine Titan-Implantationsschicht erzeugt.

Nachfolgend wird Argon und Acetylen eingeleitet und ein Druck von 4 · 10⁻³ mbar eingestellt. Gleichzeitig wird das negative Substratpotential auf -80 V vermindert und es werden die beiden UBM-Kathoden 10, 13 zugeschaltet.

Bei dem gleichzeitigem Betrieb der HIPIMS-Kathode 9 und der UBM-Kathoden 10, 13 wird eine Mehrlagenbeschichtung mit TiC/C in der Schichtarchitektur gemäß Fig. 1 aufgebracht.

Der Reibungskoeffizient µ dieser Schicht ist kleiner 0,2.

### Beispiel 3

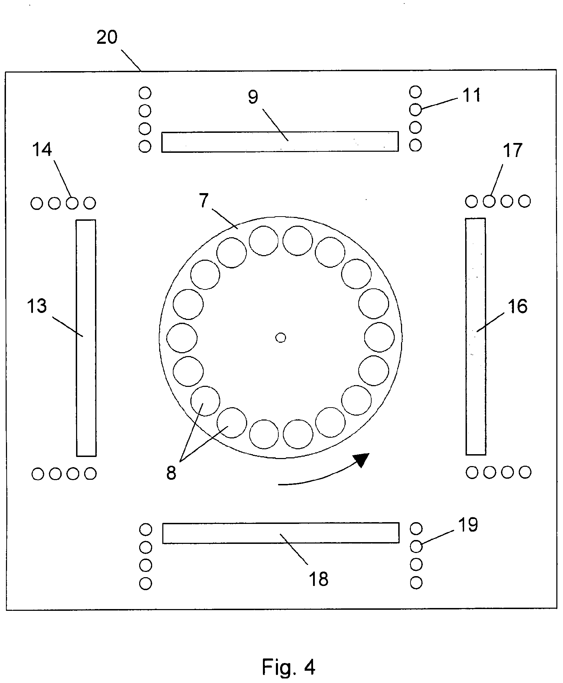

Die in Fig. 4 gezeigte dritte Ausführungsform einer Prozeßkammer 20 enthält vier Beschichtungsquellen, das sind zwei HIPIMS-Kathoden 9, 16 und zwei UBM-Kathoden 13, 18 und wird vorzugsweise für mittelgroße und große Einkammer-Anlagen eingesetzt. In einer Anlage vom Typ Z1200 der Firma Systec System- und Anlagenbau GmbH & Co. KG., Karlstadt, Deutschland, mit einem quadratischen Vakuumkessel mit Innenabmessungen 1500 mm x 1500 mm (Länge x Breite) und 1500 mm Kesselhöhe werden 950mm lange Linearkathoden eingesetzt. Die beiden HIPIMS-Kathoden 9, 16 sind mit Chrom Targetmaterial und die UBM-Kathoden 13, 18 sind mit Ti/Al (50/50 Atom-%) als Targetmaterial ausgerüstet. Zwischen den Kathoden befindet sich in zentraler Position ein rotierender Substratträger 7, der einen Durchmesser von 400 mm besitzt und über eine Höhe von 600 mm bestückt werden kann. Auf dem Substratträger sind z.B. zehn rotierende Planeten mit 150 mm Durchmesser eingesetzt, die mit für die Vakuumbeschichtung vorgereinigten, sauberen Substraten 8 bzw. Bauteilen aus dem Werkstoff 100Cr6 bestückt sind.

Die HIPIMS-Kathoden 9, 16 sind mit Solenoid-Elektromagneten 11, 17 und die beiden UBM-Kathoden 13, 18 sind mit Solenoid-Elektromagneten 14, 19 ausgerüstet.

Nach dem Beladen der Anlage wird die Kammertür geschlossen und es wird durch Abpumpen in der Vakuumkammer der Kammerdruck von Atmosphäre bis zu einem Druck von < 3 · 10⁻⁵ mbar abgesenkt. Nachfolgend wird Argon in die Kammer eingelassen bis ein Druck von 2,5 · 10⁻³ mbar erreicht ist.

Durch den Betrieb der HIPIMS-Kathoden 9, 16 findet beim Anlegen eines Substratpotentials von -1200 V gleichzeitig ein Ionenätzprozeß und ein Beschichtungsprozeß statt, durch den eine Chrom-Implantationsschicht erzeugt wird.

Nachfolgend wird Argon und Stickstoff eingeleitet und ein Druck von 7 · 10⁻³ mbar eingestellt. Gleichzeitig wird das negative Substratpotential auf -75 V vermindert und es werden zusätzlich die beiden UBM-Kathoden 13, 18 eingeschaltet.

Bei dem gleichzeitigem Betrieb der beiden HIPIMS-Kathoden 9, 16 und der UBM-Kathoden 13, 18 wird eine Mehrlagenbeschichtung aus CrN/TiAlN mit einem Doppelschichtaufbau gemäß Fig. 1 erzeugt.

Um die Härte der entstehenden Schichten zu optimieren, wird eine Schichtdicke von 3 bis 4 nm der CrN/TiAlN-Doppelschichten angestrebt. Die sich einstellende Schichthärte liegt bei ca. 48 GPa.

Für die PVD-Beschichtung werden Materialien eingesetzt, die in der nachfolgenden Tabelle zusammengestellt sind:

| **Implantationsschicht** | **HIPIMS-Schicht** | **UBM-Schicht** | **Schichttyp** |
|---|---|---|---|
| Ti | TiN | TiAlN | TiN/TiAlN |
| Cr | CrN | TiAlN | CrN/TiAlN |
| Ti | TiN | NbN | TiN/NbN |
| W | W | C | W/C |
| Ta | Ta | C | Ta/C |
| Ti | Ti | C | Ti/C |
| V | V | TiAlN | V/TiAlN |
| Cr | CrN | NbN | CrN/NbN |

Mit der Erfindung wird ein Verfahren zum Betrieb einer Mehrkathoden-PVD-Beschichtung geschaffen, basierend auf den Kathodenzerstäubungsvarianten HIPIMS und UBM. Zur Substratvorbehandlung werden die Kathoden im HIPIMS-Modus betrieben, während der Beschichtung werden die Kathoden sowohl im HIPIMS- wie auch im UBM-Modus simultan betrieben.

Dabei werden im HIPIMS- und im UBM-Modus bevorzugt unterschiedliche Targetmaterialien benutzt.

Die Schichtdicken der Material-Doppelschichten liegen bevorzugt im Bereich von 3 bis 5 nm und es tritt der Superlattice-Effekt für superharte Schichten auf, mit einer plastischen Härte > 40 GPa.

Der Abstand zwischen der einzelnen Kathode und den Substraten übersteigt 75 cm nicht.

Die Magnetfelder der einzelnen Kathode sind mittels Solenoid-Elektromagneten weitgehend magnetisch verkoppelt.

Durch die Solenoid-Elektromagneten, mit denen die Kathoden ausgerüstet sind, wird im Kathodenplasma der Unbalance-Effekt erzeugt. Die Magnetron-Kathoden sind mit balancierten Permanentmagneten ausgerüstet. Die Materialien der Permanentmagneten sind beispielsweise NdFeB oder SmCo.

Die magnetfeldunterstützte Hochleistungs-Impuls-Magnetron-Kathodenzerstäubung (HIPIMS) wird unter folgenden Entladungsbedingungen betrieben. Die dem auf der HIPIMS-Kathode montierten Target zugeführten Impulse weisen typischerweise Leistungsdichten von 800 bis 3000 Wcm⁻² auf, bei Pulslängen von 50 bis 250 µs und Pulsintervallen von 20 bis 200 ms. Die Spitzenspannungen könnten bis zu -1200 V betragen. Die mittlere Leistungsdichte wird im Bereich von 10 Wcm⁻² gehalten. Damit ist die mittlere Leistungsdichte von HIPIMS vergleichbar mit der Leistungsdichte beim Gleichstrom UBM die ebenfalls um die 8 bis 10 Wcm⁻² liegt.

### Referenzen

[1] Industrial scale manufactured superlattice hard PVD coatings W.D. Münz, D.B. Lewis, P.E. Hovsepian, C. Schönjahn, A. Ehiasarian, I.J. Smith, Surface Engineering. 2001; vol. 17(1), pp. 15-27
[2] H.K. Tönshoff, C. Blawit, "Influence of Surface Integrity on Performance of Coated Cutting Tools", Thin Solid Films, pp. 308/309 [1997 (345-350)]
[3] Handbook of Vacuum Arc Science and Technology, by Raymond L. Boxman, David Sanders and Philip J. Martin, (1996), Noyes ISBN 0-8155-1375-5
[4] I.G. Brown, F. Feinberg and J.E. Galvin, J. Appl. Phys. 63 (1988) p. 4889
[5] Dissertation Sheffield Hallham University, Cornelia Schönjahn, Feb. 2001
[6] Optimization of in situ substrate surface treatment in a cathodic arc plasma: A study by TEM and plasma diagnostics C. Schönjahn, A.P. Ehiasarian, D.B. Lewis, R. New, W.D. Münz, R.D. Twesten, I. Petrov, Journal of Vacuum Science & Technology A: Vacuum, Surfaces, and Films. July-Aug. 2001; vol. 19(4) pt. 1-2, pp. 1415-20
[7] B. Window and S. Savides, J. Vac. Sci. Technol. A4 (1986)
[8] H. Wesemeyer, Patent Anmeldung, Arc/Magnetron, 1989
[9] Microstructures Of TiN Films Grown By Various Physical Vapor-Deposition Techniques G. Hakansson, L. Hultman, J.E. Sundgren, J.E. Greene, W.D. Münz Surface & Coatings Technology, 1991, Vol.48, No.1, pp.51-67
[10] A New Concept For Physical Vapor-Deposition Coating Combining the Methods of Arc Evaporation And Unbalanced-Magnetron Sputtering, W.D. Münz, F. Hauzer, D. Schulze, B. Buil; Surface & Coatings Technology, 1991, Vol.49, No.1-3, pp.161-167
[11] A New Method For Hard Coatings - ABS (Arc Bond Sputtering) W.D. Münz, D. Schulze, F. Hauzer Surface & Coatings Technology, 1992, Vol.50, No.2, pp.169-178
[12] Droplet Formation On Steel Substrates During Cathodic Steered Arc Metal Ion Etching, W.D. Münz, IJ Smith, D.B. Lewis, S. Creasey; Vacuum, 1997, Vol.48, No.5, pp.473-481
[13] Preferential erosive wear of droplet particles for cathodic arc/unbalanced magnetron sputtering CrN/NbN superlattice PVD coatings; H.W. Wang, M.M. Stack, S.B. Lyon, P. Hovsepian, W.D. Münz, Journal of Materials Science Letters. 15 March 2001; vol. 20(6), pp. 547-50
[14] V. Kosnetsow, PCT Anmeldung WO98/40532, EP 1038045
[15] V. Kosnetsow, K. Macak, J.M. Schneider, U. Helmersson, I. Petrov, Surf. Coat. Technol. 122 (2-3), (1999) p. 290
[16] A.P. Ehiasarian, R. New, W.D. Münz, L. Hultmann, U. Helmersson, V. Kosnetsow, Vacuum 65 (2002), p. 147
[17] Patentanmeldung, EP 1260603 A2
[18] U. Helmersson, S. Todorova, S.A. Barnett, J.E.-Sundgren, L.C. Markert, J.E. Greene, J. Appl. Phys. 62 (1987) p.481

## Patentansprüche

1. Verfahren zur Mehrkathoden-PVD-Beschichtung von Substraten, umfassend die Schritte:
(a) Vorbehandlung der Substratoberfläche durch Hochleistungs-Impuls-Magnetron-Kathodenzerstäubung (HIPIMS),
(b) Beschichtung mittels Unbalancierter-Magnetron-Kathodenzerstäubung (UBM),
(c) Beschichtung mittels HIPIMS, und
(d) ein- bis mehrfache Wiederholung der Schritte (b) und (c).

2. Verfahren nach Anspruch 1, **dadurch gekennzeichnet, daß** Schritt (a) mit einem Kathodentarget aus Metall in einer Gasatmosphäre bei einem Druck kleiner/gleich 1 · 10⁻² mbar und mit einem Substratpotential von -500 bis -2000 V erfolgt, wobei die Substratoberfläche mit ein- bis mehrfach positiv geladenen Metallionen geätzt und implantiert wird.

3. Verfahren nach Anspruch 1, **dadurch gekennzeichnet, daß** im Schritt (a) ein Inertgas oder eine Mischung von Inertgasen aus der Gruppe umfassend Argon, Krypton, Neon, Xenon und Helium verwendet wird.

4. Verfahren nach Anspruch 1, **dadurch gekennzeichnet, daß** im Schritt (a) ein Kathodentarget aus Titan, Chrom, Zirkon, Niob, Wolfram, Tantal, Molybdän, Aluminium oder Vanadium verwendet wird.

5. Verfahren nach Anspruch 1, **dadurch gekennzeichnet, daß** HIPIMS mit Puls-Leistungsdichten auf dem Kathodentarget von 800 bis 3000 W·cm⁻², Pulslängen von 50 bis 250 µs, Pulsintervallen von 20 bis 200 ms und mittlerer Leistungsdichte von 5 bis 15 W·cm⁻² durchgeführt wird.

6. Verfahren nach Anspruch 1, **dadurch gekennzeichnet, daß** die Schritte (b) und (c) simultan ausgeführt werden.

7. Verfahren nach Anspruch 1, **dadurch gekennzeichnet, daß** die in den Schritten (b) und (c) verwendeten Kathodentargets aus unterschiedlichen Materialien bestehen.

8. Verfahren nach Anspruch 6, **dadurch gekennzeichnet, daß** die in den Schritten (b) und (c) verwendeten Kathodentargets aus unterschiedlichen Materialien bestehen.

9. Verfahren nach Anspruch 1, **dadurch gekennzeichnet, daß** im Schritt (b) ein Kathodentarget aus TiAl, TiAlY, CrAl, ZrAl, Niob oder Graphit verwendet wird.

10. Verfahren nach Anspruch 1, **dadurch gekennzeichnet, daß** im Schritt (c) ein Kathodentarget aus Titan, Chrom, Wolfram, Tantal oder Vanadium eingesetzt wird.

11. Verfahren nach Anspruch 1, **dadurch gekennzeichnet, daß** in den Schritten (b) und (c) ein Substratpotential von -50 bis -200 V anliegt.

12. Verfahren nach Anspruch 1, **dadurch gekennzeichnet, daß** die Schritte (b) und (c) in einer Atmosphäre bestehend aus einem oder mehreren Inertgasen, einem oder mehreren reaktiven Gasen oder einer Mischung aus inerten und reaktiven Gasen bei einem Druck kleiner/gleich 1 · 10⁻² mbar ausgeführt werden.

13. Verfahren nach Anspruch 1, **dadurch gekennzeichnet, daß** in den Schritten (b) und (c) ein Inertgas oder eine Mischung von Inertgasen aus der Gruppe umfassend Argon, Krypton, Neon, Xenon und Helium verwendet wird.

14. Verfahren nach Anspruch 1, **dadurch gekennzeichnet, daß** in den Schritten (b) und (c) als reaktives Gas Sauerstoff, Stickstoff oder Acetylen verwendet wird.

15. Verfahren nach Anspruch 1, **dadurch gekennzeichnet, daß** bei den Schritten (a), (b) und (c) keine Droplets aus Schmelzabtrag von Targetmaterial der Kathoden erzeugt werden.

16. Vorrichtung zur Mehrkathoden-PVD-Beschichtung von Substraten mit einer oder mehreren Prozeßkammern, wobei jede Prozeßkammer mit mindestens einer HIPIMS-Kathode und mindestens einer UBM-Kathode ausgestattet ist, die Substrate auf Substratträgern fixiert sind, die Anzahl der Substratträger gleich der Anzahl der Prozeßkammern ist, in jeder Prozeßkammer der Substratträger mittig zwischen den HIPIMS- und UBM-Kathoden positioniert ist und jeder Substratträger mit einem Drehantrieb gekoppelt ist.

17. Vorrichtung nach Anspruch 16, **dadurch gekennzeichnet, daß** die UBM-Kathoden mit balancierten Permanentmagneten und Solenoid-Elektromagneten ausgestattet sind, wobei der Unbalance-Effekt des UBM-Plasmas allein durch das Magnetfeld der Solenoid-Elektromagneten erzeugt wird.

18. Vorrichtung nach Anspruch 17, **dadurch gekennzeichnet, daß** die balancierten Permanentmagnete aus NdFeB oder SmCo bestehen.

19. Vorrichtung nach Anspruch 16, **dadurch gekennzeichnet, daß** die HIPIMS- und UBM-Kathoden einer Prozeßkammer in alternierender Folge so angeordnet sind, daß ihre Oberflächen symmetrisch zu den Mittellinien eines regelmäßigen Vielecks ausgerichtet sind.

20. Vorrichtung nach Anspruch 16, **dadurch gekennzeichnet, daß** zwei oder mehr Prozeßkammern um eine Zentralkammer in einem Winkelabstand voneinander von 360°/n mit n = 2 bis 6 angeordnet und vakuumdicht mit der Zentralkammer verbunden sind.

## Claims

1. Method for multi-cathode PVD coating of substrates, comprising the following steps:
(a) pre-treatment of the substrate surface by high-power impulse magnetron cathode sputtering (HIPIMS),
(b) coating by means of unbalanced magnetron cathode sputtering (UBM),
(c) coating by means of HIPIMS, and
(d) repetition of steps (b) and (c) one or more times.

2. Method according to Claim 1, **characterized in that** step (a) is carried out with a cathode target composed of metal in a gas atmosphere at a pressure of less than or equal to 1 · 10⁻² mbar and with a substrate potential of -500 to -2000 V, with the substrate surface being etched and implanted with metal ions that have been positively charged one or more times.

3. Method according to Claim 1, **characterized in that**, in step (a), an inert gas or a mixture of inert gases is used, from the group comprising argon, krypton, neon, xenon and helium.

4. Method according to Claim 1, **characterized in that**, in step (a), a cathode target is used, composed of titanium, chromium, zirconium, niobium, tungsten, tantalum, molybdenum, aluminium or vanadium.

5. Method according to Claim 1, **characterized in that** HIPIMS is carried out using pulse power densities on the cathode target of 800 to 3000 W·cm⁻², pulse lengths of 50 to 250 µs, pulse intervals of 20 to 200 ms, and a mean power density of 5 to 15 W·cm⁻².

6. Method according to Claim 1, **characterized in that** steps (b) and (c) are carried out simultaneously.

7. Method according to Claim 1, **characterized in that** the cathode targets used in steps (b) and (c) are composed of different materials.

8. Method according to Claim 6, **characterized in that** the cathode targets used in steps (b) and (c) are composed of different materials.

9. Method according to Claim 1, **characterized in that** a cathode target composed of TiAl, TiAlY, CrAl, ZrAl, niobium or graphite is used in step (b).

10. Method according to Claim 1, **characterized in that** a cathode target composed of titanium, chromium, tungsten, tantalum or vanadium is used in step (c).

11. Method according to Claim 1, **characterized in that** a substrate potential of -50 to -200 V is applied in steps (b) and (c).

12. Method according to Claim 1, **characterized in that** steps (b) and (c) are carried out in an atmosphere comprising one or more inert gases, one or more reactive gases or a mixture of inert and reactive gases at a pressure of less than or equal to 1 · 10⁻² mbar.

13. Method according to Claim 1, **characterized in that** an inert gas or a mixture of inert gases from the group comprising argon, krypton, neon, xenon and helium is used in steps (b) and (c).

14. Method according to Claim 1, **characterized in that** oxygen, nitrogen or acetylene is used as the reactive gas in steps (b) and (c).

15. Method according to Claim 1, **characterized in that** no droplets composed of melt erosion from the target material of the cathodes are produced in steps (a), (b) and (c).

16. Apparatus for multi-cathode PVD coating of substrates using one or more process chambers, with each process chamber being equipped with at least one HIPIMS cathode and at least one UBM cathode, the substrates being fixed on substrate supports, the number of substrate supports being equal to the number of process chambers, the substrate support being positioned centrally between the HIPIMS and UBM cathodes in each process chamber, and each substrate support being coupled to a rotary drive.

17. Apparatus according to Claim 16, **characterized in that** the UBM cathodes are equipped with balanced permanent magnets and solenoid electromagnets, with the unbalance effect of the UBM plasma being produced solely by the magnetic field of the solenoid electromagnets.

18. Apparatus according to Claim 17, **characterized in that** the balanced permanent magnets are composed of NdFeB or SmCo.

19. Apparatus according to Claim 16, **characterized in that** the HIPIMS and UBM cathodes in a process chamber are arranged in an alternating sequence such that their surfaces are aligned symmetrically with respect to the centre lines of a regular polygon.

20. Apparatus according to Claim 16, **characterized in that** two or more process chambers are arranged around a central chamber at an angular distance from one another of 360 °/n where n = 2 to 6, and are connected to the central chamber in a vacuum-tight manner.

## Revendications

1. Procédé pour le revêtement physique en phase vapeur à plusieurs cathodes de substrats, comprenant les étapes de :
(a) traitement préalable de la surface de substrat par pulvérisation cathodique magnétron à impulsions haute puissance (HIPIMS),
(b) revêtement au moyen d'une pulvérisation cathodique magnéton non équilibré (UBM),
(c) revêtement au moyen d'une HIPIMS, et
(d) répétition unique à multiple des étapes (b) et (c).

2. Procédé selon la revendication 1, **caractérisé en ce que** l'étape (a) s'effectue avec une cible cathode en métal dans une atmosphère gazeuse à une pression inférieure/égale à 1·10⁻² mbar et avec un potentiel de substrat de -500 à -2000 V, dans lequel la surface de substrat est gravée et implantée avec des ions métalliques chargés positivement une ou plusieurs fois.

3. Procédé selon la revendication 1, **caractérisé en ce que**, à l'étape (a), un gaz inerte ou un mélange de gaz inertes du groupe comprenant de l'argon, du krypton, du néon, du xénon et de l'hélium est utilisé.

4. Procédé selon la revendication 1, **caractérisé en ce que**, à l'étape (a), une cible cathode en titane, chrome, zircon, niobium, tungstène, tantale, molybdène, aluminium ou vanadium est utilisée.

5. Procédé selon la revendication 1, **caractérisé en ce que** l'HIPIMS est réalisé avec des densités de puissance d'impulsion sur la cible cathode de 800 à 3000 W·cm⁻², des longueurs d'impulsion de 50 à 250 µs, des intervalles entre impulsions de 20 à 200 ms et une densité de puissance moyenne de 5 à 15 W·cm⁻².

6. Procédé selon la revendication 1, **caractérisé en ce que** les étapes (b) et (c) sont réalisées simultanément.

7. Procédé selon la revendication 1, **caractérisé en ce que** les cibles de cathode utilisées aux étapes (b) et (c) sont constituées de différents matériaux.

8. Procédé selon la revendication 6, **caractérisé en ce que** les cibles cathodes utilisées aux étapes (b) et (c) sont constituées de différents matériaux.

9. Procédé selon la revendication 1, **caractérisé en ce que**, à l'étape (b), une cible cathode en TiAI, TiAIY, CrAI, ZrAI, niobium ou graphite est utilisée.

10. Procédé selon la revendication 1, **caractérisé en ce que**, à l'étape (c), une cible cathode en titane, chrome, tungstène, tantale ou vanadium est utilisée.

11. Procédé selon la revendication 1, **caractérisé en ce que**, aux étapes (b) et (c), un potentiel de substrat de -50 à -200 V s'applique.

12. Procédé selon la revendication 1, **caractérisé en ce que** les étapes (b) et (c) sont réalisées dans une atmosphère constituée d'un ou de plusieurs gaz inertes, d'un ou de plusieurs gaz réactifs ou d'un mélange de gaz inertes et réactifs pour une pression inférieure/égale à 1·10⁻² mbar.

13. Procédé selon la revendication 1, **caractérisé en ce que**, aux étapes (b) et (c), un gaz inerte ou un mélange de gaz inertes du groupe comprenant argon, krypton, néon, xénon et hélium est utilisé.

14. Procédé selon la revendication 1, **caractérisé en ce que**, aux étapes (b) et (c), de l'oxygène, de l'azote ou de l'acétylène est utilisé comme gaz réactif.

15. Procédé selon la revendication 1, **caractérisé en ce que**, aux étapes (a), (b) et (c), aucune gouttelette provenant de l'enlèvement de matière fondue de matériau cible des cathodes n'est produite.

16. Dispositif pour le revêtement physique en phase vapeur à plusieurs cathodes de substrats avec une ou plusieurs chambres de traitement, dans lequel chaque chambre de traitement est équipée d'au moins une cathode HIPIMS et d'au moins une cathode UBM, les substrats sont fixés sur des supports de substrats, le nombre des supports de substrats est égal au nombre des chambres de traitement, le support de substrat est positionné au centre entre les cathodes HIPIMS et UBM dans chaque chambre de traitement et chaque support de substrat est accouplé à un entraînement rotatif.

17. Dispositif selon la revendication 16, **caractérisé en ce que** les cathodes UBM sont équipées d'aimants permanents équilibrés et d'électroaimants solénoïdes, dans lequel l'effet de non-équilibre du plasma UBM est produit uniquement par le champ magnétique des électro-aimants solénoïdes.

18. Dispositif selon la revendication 17, **caractérisé en ce que** les aimants permanents équilibrés sont constitués de NdFeB ou de SmCo.

19. Dispositif selon la revendication 16, **caractérisé en ce que** les cathodes HIPIMS et UBM d'une chambre de traitement sont disposées en suite alternante, de sorte que leurs surfaces sont orientées de manière symétrique par rapport aux lignes médianes d'un polygone régulier.

20. Dispositif selon la revendication 16, **caractérisé en ce que** deux chambres de traitement ou plus sont disposées autour d'une chambre centrale dans un écart angulaire l'une de l'autre de 360°/n avec n = 2 à 6 et sont reliées à la chambre centrale de manière étanche au vide.
